Europäisches Patentamt

(19) European Patent Office

Office européen des brevets

(11) Publication number: **0 113 007**
**B1**

(12) **EUROPEAN PATENT SPECIFICATION**

(45) Date of publication of patent specification: **27.04.88**

(21) Application number: **83111412.9**

(22) Date of filing: **15.11.83**

(51) Int. Cl.⁴: **B 41 M 5/24,** B 41 C 1/10, G 03 F 1/00

(54) **Recording materials having a surface lubricant layer for use in electroerosion printing.**

(30) Priority: **30.12.82 US 454744**

(43) Date of publication of application:
**11.07.84 Bulletin 84/28**

(45) Publication of the grant of the patent:
**27.04.88 Bulletin 88/17**

(84) Designated Contracting States:
**DE FR GB**

(56) References cited:
**DE-A-1 496 152**
**DE-A-2 434 105**
**FR-A-2 333 406**
**GB-A-1 244 177**
**GB-A-1 545 726**
**US-A-3 411 948**
**US-A-4 086 853**

**DERWENT JAPANESE PATENT REPORT, vol. 75, no. 25, July 18, 1975, section G, page 2, "Electron-sensitive recording medium"**

**JAPANESE PATENT REPORT, vol. 77, no. 16, March 10, 1977, page 3 G, "Electric diescharge surface destructible recording material"**

(73) Proprietor: **International Business Machines Corporation**
**Old Orchard Road**
**Armonk, N.Y. 10504 (US)**

(72) Inventor: **Cohen, Mitchell Simmons**
**23 Gregory Lane**
**Ossining New York 10562 (US)**

(74) Representative: **Burt, Roger James, Dr.**
**IBM United Kingdom Limited Intellectual Property Department Hursley Park**
**Winchester Hampshire SO21 2JN (GB)**

(56) References cited:
**JAPANESE PATENT REPORT, vol. 80, no. 6, March 7, 1980, page 5 G, "Electric discharge recording paper"**

Courier Press, Leamington Spa, England.

## Description

The invention relates to electroerosion printing and more particularly to recording materials for use in such printing.

Electroerosion printing is a well-known technique for producing markings, such as, letters, numbers, symbols, patterns, such as, circuit patterns, or other legible or coded indicia on recording material in response to an electric signal which removes or erodes material from the surface of the recording material as the result of spark initiation.

The surface which is eroded or removed to provide such indicia on the recording material is usually a thin film of conductive material which is vaporized in response to localized heating associated with sparking (arcing) initiated by applying an electric current to an electrode in contact with the surface of a recording material comprising the thin conductive film on a non-conductive backing or support. In the present state of the technology the thin conductive film is usually a thin film of vaporizable metal, such as, aluminum.

Electroerosion printing is effected by the movement of a stylus or a plurality of styli relative to the surface of specially prepared recording media. Electrical writing signals are fed to the stylus to provide controlled electrical pulses which generate sparks at the surface of the recording material to selectively heat and remove by evaporation a layer of recording material the locations from which is removed correspond to the indicia or images which are to be recorded.

In the course of this process, the stylus is moved relatively to a surface of the recording material and in contact with the removable layer, e.g., a thin film of vaporizable material, usually a metal, such as, aluminum.

### Prior art

Due to the fragility of the thin conductive layer and stylus pressure, considerable scratching (undesired removal of the removable layer) is observed to take place during electroerosion printing.

We have found that improved electroerosion recording materials can be prepared by applying to the surface of such materials a layer of lubricating conductive material in a polymeric binder. The general class of laminar solids may be employed as such lubricating conducting agents. Examples of such solids are $MoS_2$, $WS_2$, $VSe_2$, $TaSe_2$, $TaS_2$ and graphite. Other soft compounds may be considered such as $AgI$, $PbO$, $Pb(OH)_2$, $PbCO_3$, $CaF_2PbO$ since they have all been shown to be lubricants. In addition, soft metal particles such as Sn, Cu, Zn, Ag, Pb, Au, Bi, and Al are expected to be useful in the invention. Work has been carried out with $MoS_2$, Al, and Zn, but the most satisfactory results have been obtained with graphite since it is cheap, effective, and easy to disperse. The overlayers · of lubricating conductive materials in polymeric binder may be applied directly to the surface of electroerosion recording materials.

US—A—4086853 discloses a printing blank coated with a solid and electrically partially conductive protective layer serving to inhibit mechanical abrasion of said layer during inscription of the blank with an electrical stylus. The layer comprises finely divided electrically active material e.g. carbon in a film forming resin material.

DE—A—2434105 discloses a difusely reflecting over layer consisting of zinc oxide mixed with a bonding agent. The zinc oxide consists of a rod or pin-shaped particles since this has been found to improve the recording quality.

JP—A—7501 6663 discloses electroerosion recording material including a non-conductive support layer, a thin conductive layer on the support layer and capable of being removed in selected areas thereof by electroerosion due to a recording stylus, and an overlayer located on the stylus-contacting surface of the thin conductive layer. The overlayer comprises a mixture of pigment and binder and does not comprise laminar solid conducting lubricating particles.

One object of the invention, therefore, is to produce electroerosion recording materials of improved resistance to stylus scratching by use of the special lubricating coatings of this invention.

Another object of the invention is to provide a superior lubricant composition which also exhibits improved contrast when used to produced direct-negative by electroerosion printing. In such usage the dark graphite/polymer film serves to help block light that may be partially transmitted through the thin conductive film, e.g., a thin aluminium film.

The materials incorporated in the recording materials of this invention also have the advantage of coating the recording styli with a light, fluffy, easily removable layer because of their high lubricity. This layer inhibits the build-up of organic residue layers which could cause fouling or "baking" of debris onto the styli which in turn prevents good writing.

Another advantage of the lubricating layers of this invention is that they are electrically conductive and therefore can be used in thinner layers than can insulating lubricant films. The conductivity provided by the graphite appears to enhance the dielectric breakdown through the overlayer.

Further, the lubricants of this invention may be incorporated in a layer which provides both protection to the recording sheet during handling and lubrication during the electroerosion process.

Accordingly the invention provides electroerosion recording material including a non-conductive support layer, a thin conductive layer on the support layer and capable of being removed in selected areas thereof by electroerosion due to a recording stylus, and an overlayer located on the stylus-contacting surface of the thin conductive layer, characterised in that the overlayer is a solid layer comprised of laminar solid conductive lubricating particles dispersed in a polymeric binder, the thickness of the overlayer being from about 5 to 50 microprogrammes per square centimeter, and the ratio by volume of binder to particles being sufficient substantially to prevent particle flake off during handling and use of the material.

The invention will now be further described with reference to the accompanying drawings, in which:

Fig. 1 of the drawings is a general schematic rendering of an illustrative electroerosion printing system; and

Fig. 2 of the drawings is a cross-sectional view of a sheet of electroerosion material made in accordance with this invention and showing the removal of surface layers in regions where electroerosion has been effected.

The present invention generally comprises electroerosion recording materials coated, on their stylus contacting surface, with a lubricant composition comprising lubricating particles of good electric conductivity in a polymeric binder. Electroerosion materials for use as direct-negative or direct masters can be prepared utilizing this invention. The lubricating layer should have a density between about 5 and 50 micrograms per square centimeter since lower concentrations give in adequate lubrication and higher concentrations are too thick for good writing at low writing voltages (about 50 V) and short pulse lengths (about 20 microseconds). If more energy is applied by increasing the voltage of the writing pulse and increasing the pulse length, thicker films can be used. Also the lubricating agent binder ratio should be adjusted to avoid flakeoff of the lubricating agent.

Any conductive laminar solid may be used as the conductive agent for the lubricating layer. Graphite is preferred as $MoS_2$, Al and Zn have been demonstrated. Other materials which are expected to be useful include, for example, $WS_2$, $VSe_2$, $TaSe_2$, AgI, PbO, $Pb(OH_2)$, $PbCO_3$, $CaF_2PbO$, Sn, Cu, Ag, Pb, Au, Bi, etc.

Any film forming polymer which is compatible with and capable of dispersing the lubricating conductive agent and which does not cause stylus fouling during electroerosion printing can be used as the binder in the composition of this invention.

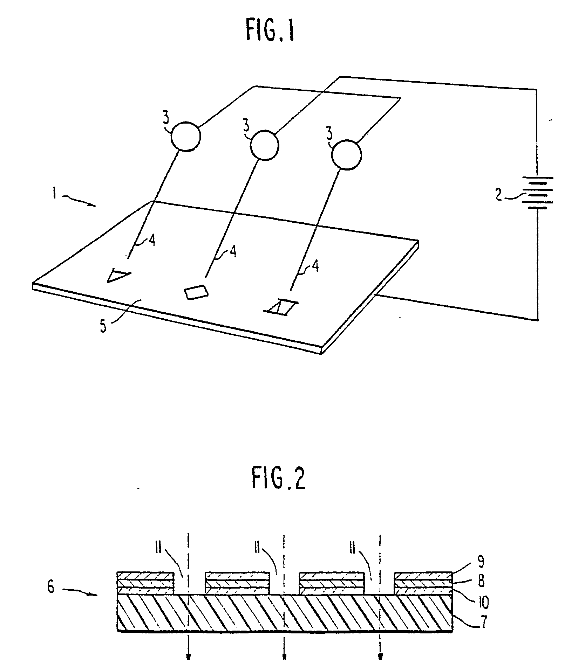

The detailed description of the invention can be better appreciated by reference to the accompanying drawings. Fig. 1 illustrates schematically an electroerosion printing system 1 which includes a source of electrical energy 2, which is connected with writing control means 3 for controlling the flow (voltage and pulse length) of electrical current to styli 4 which are electrodes which contact the surface of the electroerosion recording material 5.

In operation, electric current pulses corresponding to information to be printed on the recording material 5 are transmitted through the writing control systems 3 to the styli 4. As a result, electrical discharges are generated at the surface of the recording material 5, and the temperature of the thin surface film is locally raised causing evaporation of the surface film or layer and exposing the underlying material to produce the desired image.

Means (not shown) are provided for moving the styli 4 relative to and in contact with the surface of the recording material 5. As the styli 4 move relative to the recording material 5 and the writing control means 3 direct pulses of current to the styli of sufficient voltage to cause arcing and evaporation of a conductive layer of the material, there can be recorded desired information, patterns and graphics of any kind. It is during the movement of the styli over and in contact with the surface of the recording material that the thin film on the surface of the recording material is liable to be scratched and abraded resulting in poor writing quality and perhaps the recording of erroneous information.

Referring to Fig. 2, the electroerosion recording material of this invention 6 is shown in cross section to comprise a support 7 of paper, polymer film, etc., a thin, conductive, evaporable layer or film 8, and a lubricant layer or film 9; optionally a tough, hard, transparent film 10 may be positioned between the support 7 and the evaporable layer 8. This film which preferably is of a crosslinked polymer and which may be light transmissive or transparent serves further to reduce scratching of the material during electroerosion printing. This is further described in EP—A—113,005 of even date, which has now been abandoned. The evaporable film 8 usually has a resistance of from about 1 to 5 ohms per square and is frequently a vapor-deposited thin film of aluminum.

Where the backing or support is a light transparent or transmissive material, the resulting product can be used as a photomask or direct-negative medium for the development of photosensitive materials, e.g., in the production of offset lithography masters, circuit boards, etc. Where the styli have been energized and the lubricant film and conductive film burned off light windows 11 are provided through the transparent backing so that the material is rendered selectively light (arrows) transmissive and may then be used in direct-photonegative or like applications.

Where the material is to be used as an offset master the support should be chosen to be an ink receptive material such as polyester. After imaging by electroerosion printing to expose the support layer selectively, the overlayer of lubricating composition is removed, for example, by applying a solvent for the polymeric binder. This exposes the conductive layer which must be ink repellent. Aluminum is the commonly used material for the conductive layer and carries a thin aluminum oxide surface film which is inherently hydrophilic, i.e., repellent to oil based inks.

Electroerosion recording materials of the invention may be prepared in accordance with the following procedure:

As a support, a sheet of polyester 50 micrometers thick was provided. On this support, using conventional web-coating apparatus, a coating of silica particles in a crosslinked CAB binder was put down, as is described in aforesaid EP—A—113,005. Onto this layer there was evaporation deposited, by conventional technique, a thin conductive film of aluminum, having a resistance of between 1 and 5 ohms per square.

Finally, using conventional web-coating apparatus a lubricating film was coated onto the dielectric layer.

The coating from which the lubricating layer or film was deposited comprised a solution containing the following ingredients in the indicated approximate percentages by weight

| Graphite | 16% |
| Polymeric binder | 4% |
| Solvent | 80% |

To apply this coating it was convenient to make a considerable further dilution of perhaps about 5:1 in additional solvent. A suitable composition for the lubricant has been found to be available commercially as Electro-dag 154 from Acheson Colloid Co. or similar products from Graphite Products Corp. or Superior Graphite Corp.; Electro-dag 154 comprises graphite, ethyl cellulose binder and isopropanol solvent in the above proportions. After the coating is applied, only a short drying cycle (about 3 minutes at 100°C) is needed to drive off the solvent.

Other binders can be used in the lubricant layer such as other cellulosics, e.g., cellulose acetate butyrate, or hydroxy ethyl cellulose, or materials like vinyl acetate, polycarbonate, styrene anhydride (SMA from Arco Co.) various acrylates, and a wide variety of other binders.

It is found that a wide range of binder concentrations can be effectively used, e.g., from about 20% binder to 80% graphite, as offered by vendors, to from about 80% binder to 20% graphite, as can be made by adding additional binder. The binder typically used is cellulose acetate butyrate (CAB 553.4 from Eastman Chemical Corp.) dissolved in an 80%, 20% mixture of methyl ethyl ketone and toluene. The change in binder concentration changes the electrical conductivity of the overlayer. Depending on the details of the driver circuitry of the electroerosion printing system, in particular the maximum initial current which can be delivered by the drivers, it may be advantageous to employ a higher binder content.

It is further noted that the high-binder content materials are fairly transparent, being only grayish in thin layers. Under these circumstances such layers could be used for electroerosion paper, giving reduced scratching in that application.

Another advantage of higher binder content is that there is less tendency of the overlayer to smudge or flake off during handling. It is estimated that about 30% binder and above is satisfactory for this purpose.

It may be noted that in the case of too high binder content, e.g., over about 80% there may be danger of stylus fouling from the debris. Therefore the binder chemistry must be chosen with care; binders with high glass transition temperatures are better in that regard.

The solvent for the lubricating material-binder solids is not critical, as it need only be capable of satisfactorily dissolving the solids to provide a composition compatible with the coating technique which is utilized. Some available graphite-binder solids are provided in isopropanol solvent, while others incorporate trichlorethane and many other solvents are no doubt useful in the invention.

In using materials prepared as described above, writing signals in the range of from about 30 to 60 volts are satisfactory to electroerode the conductive layer of these materials to expose the underlayer.

## Claims

1. Electroerosion recording material (5) including a non-conductive support layer (7) a thin conductive layer (8) on the support layer (7) and capable of being removed in selected areas thereof by electroerosion due to a recording stylus (4), and an overlayer (9) located on the stylus-contacting surface of the thin conductive layer (8), characterised in that the overlayer (9) is a solid layer comprised of laminar solid conductive lubricating particles dispersed in a polymeric binder, the thickness of the overlayer (9) being from about 5 to 50 microgrammes per square centimeter, and the ratio by volume of binder to particles being sufficient substantially to prevent particle flake off during handling and use of the material.

2. A material according to claim 1, characterised in that the conductive lubricating particles are of graphite.

3. A material according to claim 1 or 2, characterised in that the amount of binder in the overlayer (9) is from 20% to 80% by weight of the overlayer and the balance is made of solid lubricating particles.

4. A material according to any preceding claim, characterised in that an additional transparent layer (10) is located between the thin conductive layer (8) and the support layer (7).

5. A material according to any preceding claim, characterised in that the support layer (7) is of a light transmissive material, such that, after electroerosion of the conductive member, the material may be utilized in direct-negative applications.

6. A method of electroerosion recording comprising providing a sheet (5) of electroerosion recording material according to any preceding claim, a multi-stylus recording head (4) for applying electrical pulses through the overlayer (9) to the thin conductive layer (8) to remove it at selected locations, wherein the electrical pulses are of short duration (e.g. 20 microseconds) and have voltages in the range of from about 30 to 60 volts.

7. A method for preparing a direct negative for use in photographic reproduction, comprising providing a sheet of electroerosion recording material according to any of claims 1 to 5, and subjecting the material to electroerosion recording to remove the overlayer and the conductive layer in selected imaged area, thus creating light transmissive paths through the material in the imaged areas.

8. A method of preparing an offset master by electroerosion recording, comprising providing a sheet of electroerosion recording material according to any of claims 1 to 5, in which the support layer (7) is ink receptive and the conductive layer (8) is ink repellent, subjecting the material to electroerosion recording to remove the overlayer (9) and the conductive layer (8) in selected imaged area, thus selectively exposing the ink receptive support layer (7) in the imaged areas, and removing the overlayer (9) by applying the material a solvent for the binder, thus exposing in the unimaged areas, the ink repellent surface of the conductive layer.

## Patentansprüche

1. Elektroerosives Aufzeichnungsmaterial (5), mit einer nichtleitenden Trägerschicht (7), einer dünnen leitenden Schicht (8), welche auf die Trägerschicht (7) aufgebracht ist und von ausgewählten Bereichen dieser Schicht durch Elektroerosion mittels einer Brennadel (4) entfernt werden kann, und mit einer Deckschicht (9), welche sich auf der Oberfläche der dünnen, leitenden Schicht (8) befindet, die von der Brennadel berührt wird, dadurch gekennzeichnet, daß die Deckschicht (9) eine Festkörperschicht aus lamellenförmigen, festen, leitenden Schmiermittelteilchen ist, die in einem polymeren Bindemittel feinst verteilt sind, wobei die Dicke der Dechschicht (9) ca. 5—50 Mikrogramm pro cm² beträgt und wobei das Verhältnis von Bindemittelvolumen zu Teilchen ausreichend ist, um das Abblättern von Teilchen während der Handhabung und der Benutzung des Materials zu verhindern.

2. Material nach Anspruch 1, dadurch gekennzeichnet, daß die leitenden Schmiermittelteilchen aus Graphit bestehen.

3. Material nach Anspruch 1 oder 2, dadurch gekennzeichnet, daß die Bindemittelmenge in der Deckschicht (9) zwischen 20—90 Gew.-% dieser Schicht ausmacht und daß der Rest aus festen Schmiermittelteilchen besteht.

4. Material nach einem der vorhergehenden Ansprüche, dadurch gekennzeichnet, daß zwischen der dünnen, leitenden Schicht (8) und der tragenden Schicht (7) eine zusätzliche transparente Schicht (10) aufgebracht ist.

5. Material nach einem der vorhergehenden Ansprüche, dadurch gekennzeichnet, daß die tragende Schicht (7) aus einem aus einem lichtdurchlässigen Material besteht, so daß das Material nach der elektroerosiven Bearbeitung des leitenden Materials für direkt-negative Anwendungen verwendet werden kann.

6. Verfahren zur Elektroerosions-Aufzeichnung, gekennzeichnet durch eine dünne Platte (5) aus elektroerosionsaufzeichnendem Material nach einem der vorhergehenden Ansprüche, einen Aufzeichnungskopf (4) mit mehreren Brennadeln zum Aufbringen elektrischer Impulse durch die Deckschicht (9) auf die dünne, leitende Schicht (8), so daß diese an ausgewählten Stellen entfernt werden kann, wobei die elektrischen Impulse kurz sind (z.B. 20 Mikrosekunden) und Spannungen zwischen 30 bis 60 Volt aufweisen.

7. Verfahren zum Vorbereiten eines Direkt-Negativs für eine Photo-Reproduktion, dadurch gekennzeichnet, daß eine dünne Platte aus elektroerosionsaufzeichnendem Material nach einem der Ansprüche 1 bis 5 vorgesehen ist und daß das Material einer Elektroerosions-Aufzeichnung ausgesetzt wird, so daß die Deckschicht und die leitende Schicht von ausgewählten nutzbaren Bildbereichen entfernt werden kann, wodurch in den nutzbaren Bildbereichen durch das Material verlaufende lichtdurchlässige Pfade gebildet werden.

8. Verfahren zum Vorbereiten eines Offset-Originals durch Elektroerosionsaufzeichnung, dadurch gekennzeichnet, daß eine dünne Platte aus elektroerosionsaufzeichnendem Material nach einem der Ansprüche 1 bis 5 vorgesehen ist, wobei die tragende Schicht (7) Farbe aufnehmen und die leitende Schicht (8) Farbe abweist, daß das Material einer Elektroerosionsaufzeichnung ausgesetzt wird, um die Deckschicht (9) und die leitende Schicht (8) von ausgewählten nutzbaren Bildbereichen zu entfernen, wodurch die farbaufnehmende tragende Schicht (7) bei den nutzbaren Bildbereichen selektiv bloßgelegt wird, und daß die Deckschicht (9) entfernt wird, indem das Material einem Lösungsmittel für das Bindemittel ausgesetzt wird, so daß bei den nichtnutzbaren Bereichen die farbabweisende Oberfläche der leitenden Schicht freigelegt wird.

## Revendications

1. Matériau d'enregistrement par électroérosion (5) comportant une couche de support non conductrice (7), une couche conductrice mince (8) sur la couche de support (7) et susceptible d'être retirée dans des zones sélectionnées de celle-ci grâce à une électroérosion due à un stylet d'enregistrement (4), et une couche de recouvrement (9) située sur la surface venant en contact avec le stylet de la couche conductrice mince (8), caractérisé en ce que la couche de recouvrement (9) est une couche solide composée de particules lubrifiantes conductrices solides lamellaires dispersées dans un liant polymère, l'épaisseur de la couche de recouvrement (9) étant comprise entre 5 et 50 microgrammes par centimètre carré environ, et le support volumique liant-particules étant substantiellement suffisant pour éviter le détachement de particules durant la manipulation et l'utilisation du matériau.

2. Matériau selon la revendication 1, caractérisé en ce que les particules conductrices lubrifiantes sont en graphite.

3. Matériau selon la revendication 1 ou 2, caractérisé en ce que la proportion de liant dans la couche de recouvrement (9) est comprise entre 20% et 80% en poids de la couche de recouvrement et en ce que le reste est composé de particules lubrifiantes solides.

4. Matériau selon l'une quelconque des revendications précédentes, caractérisé en ce qu'une couche transparente additionnelle (10) est disposée entre la couche conductrice mince (8) et la couche de support (7).

5. Matériau selon l'une quelconque des revendications précédentes, caractérisé en ce que la couche de support (7) est en un matériau transmettant la lumière, de telle sorte que, après l'électroérosion de l'élément conducteur, le matériau puisse être utilisé dans des applications de négatif direct.

6. Procédé d'enregistrement par électroérosion comportant la disposition d'une feuille (5) de matériau d'enregistrement par électroérosion selon l'une quelconque des revendications précédentes, une tête d'enregistrement (4) à stylets multiples pour appliquer des impulsions électriques, à travers la couche de recouvrement (9), à la couche conductrice mince (8) afin de la retirer en des emplacement sélectionnés, dans lequel les impulsions électriques sont de courte durée (20 microsecondes, par exemple) et ont des tensions comprises dans la plage située entre 30 et 60 volts environ.

7. Procédé pour préparer un négatif direct pour l'utilisation en reproduction photographique, comportant la disposition d'une feuille de matériau d'enregistrement par électroérosion selon l'une quelconque des revendications 1 à 5, et l'exposition du matériau à un enregistrement par électroérosion afin de retirer la couche de recouvrement et la couche conductrice dans des zones d'image sélectionnées, en créant ainsi des chemins de transmission de la lumière à travers la matériau dans les zones d'image.

8. Procédé pour préparer un film offset par enregistrement par électroérosion, comportant la disposition d'une feuille de matériau d'enregistrement par électroérosion selon l'une quelconque des revendications 1 à 5, dans lequel la couche de support (7) est imprimable et la couche conductrice (8) repousse l'encre, l'exposition du matériau à un enregistrement par électrosion afin de retirer la couche de recouvrement (9) et la couche conductrice (8) dans des zones d'image sélectionnées, en exposant ainsi sélectivement la couche de support imprimable (7) dans les zones d'image, et l'enlèvement de la couche de recouvrement (9) en appliquant au matériau un solvant pour le liant, en exposant ainsi dans les zones non imagées la surface repoussant l'encre de la couche conductrice.

## FIG.1

## FIG.2